Europäisches Patentamt

European Patent Office

Office européen des brevets

(11) Publication number: **0 222 021 B1**

# EUROPEAN PATENT SPECIFICATION

(45) Date of publication of patent specification: **17.03.93**  (51) Int. Cl.5: **H03M 1/66**, H03M 1/82, G06J 1/00

(21) Application number: **86902912.4**

(22) Date of filing: **09.05.86**

(86) International application number:
**PCT/JP86/00240**

(87) International publication number:
**WO 86/06896 (20.11.86 86/25)**

(54) **D/A CONVERTER.**

(30) Priority: **09.05.85 JP 98559/85**

(43) Date of publication of application:
**20.05.87 Bulletin 87/21**

(45) Publication of the grant of the patent:
**17.03.93 Bulletin 93/11**

(84) Designated Contracting States:
**DE FR GB NL**

(56) References cited:
**GB-A- 2 018 066**
**JP-A- 5 034 772**
**JP-A- 5 620 329**
**JP-A-58 115 925**

**IEEE 1983 INTERNATIONAL SYMPOSIUM ON CIRCUITS AND SYSTEMS, Newport Beach, California, 2nd - 4th May 1983, vol. 3, pages 1270-1273, IEEE, New York, US; K. WATANABE et al.: "A switched-capacitor digital multiplier"**

**ELEKTRONIK, vol. 31, no. 3, February 1982,**

pages 78-80, Munich, DE; G. HEINLE: "Gleitkomma-D/A-Umsetzer verringert Ouantisierungsfehler"

(73) Proprietor: **SONY CORPORATION**
**7-35 Kitashinagawa 6-chome Shinagawa-ku Tokyo 141(JP)**

(72) Inventor: **AKAGIRI, Kenzo**
**Sony Corporation 7-35, Kitashinagawa 6-chome**
**Shinagawa-ku Tokyo 141(JP)**

(74) Representative: **TER MEER - MÜLLER - STEINMEISTER & PARTNER**
**Mauerkircherstrasse 45**
**W-8000 München 80 (DE)**

**Description**

This invention relates to a D/A converter which is arranged to output the product of two digital signals as an analog signal.

In an article having the title "A Switched-Capacitor Digital Multiplier", published in IEEE 1983, International Symposium on Circuits and Systems, Newport Beach, California, May 2 to 4, 1983, Vol. 3, pages 1270 - 1273, written by K. Watanabe and G. C. Temes, a D/A converter is described which comprises the following features:
- a means for outputting a first digital signal and a second digital signal;
- a constant voltage generating circuit;
- an integration circuit;
- a switched capacitor circuit arranged between said constant voltage generating circuit and said integration circuit; and
- a control circuit means for controlling the operation of said switched capacitor circuit;
- whereby said integration circuit outputs an analog signal proportional to the product of said first and second digital input signals.

In this converter, the control circuit means comprises an m-bit programmable binary-weighted capacitor array, the capacitance of which is programmed by the multiplicant x, and it comprises a n-bit programmable binary-weighted capacitor array, the capacitance of which is programmed by the multiplier y. One of these capacitances determines the switching frequency of the switched capacitor circuit, and the other one determines the amount of charges which are integrated with each switching operation.

GB-A-2 018 066 describes a D/A converter using a counter and a register for multiplying two digital input signals and for outputting the product as an analog signal. The first signal is input into the register, and its value determines, under the control of a control logic, the count step width of the counter, i. e. 1, 2, 4, 8 or 16 decimal numbers per step. Therefore, the counting period of the counter depends on the step width with which it is controlled by the first digital signal. The analog signal output by the control logic as the signal representing the product of the two input digital signals corresponds to said counting period.

It is the object of the present invention to provide a D/A converter having simple construction, but being able anyhow to output the product of two digital input signals as an analog signal.

The D/A converter of the present invention comprises the above listed features of the prior art converter, and it is characterized in that said control circuit means comprises:
- a switching clock generator for outputting switching pulses determining the switching frequency of said switching capacitor circuit;
- a first control circuit for determining a number of time periods from the value of said first digital signal; and
- a second control circuit for determining the duration of said time period, during which said switching capacitor means is switched, said duration being dependend from the value of said second digital signal.

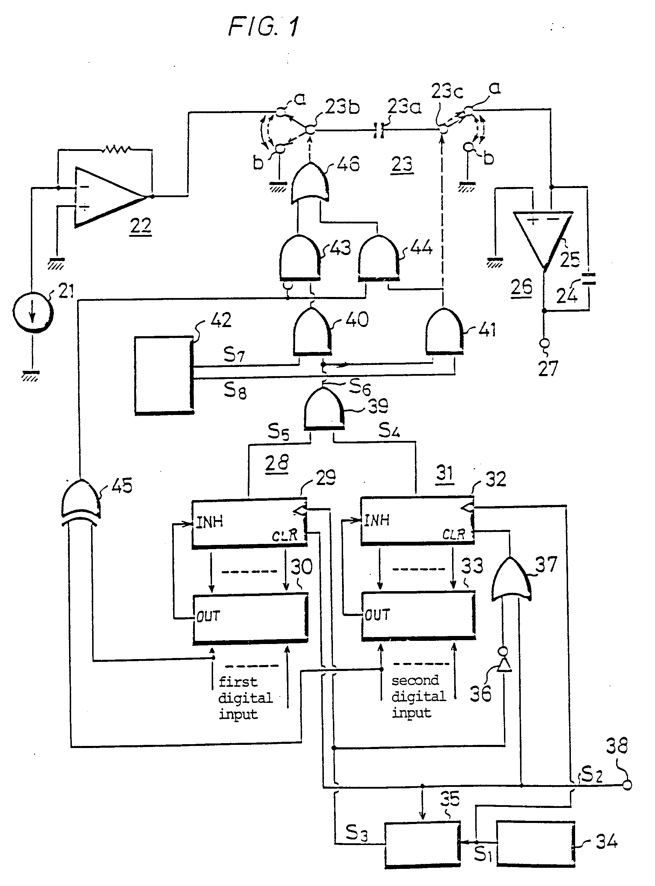

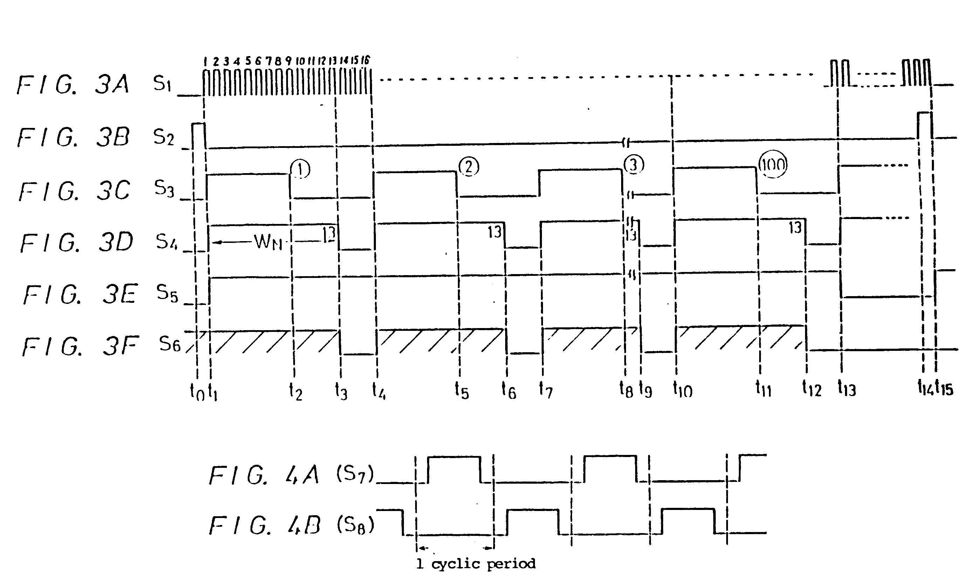

Fig. 1 is a block diagram showing an embodiment according to the invention, Figs. 3 and 4 are signal wave form charts used to explain the operation of the embodiment shown in Fig. 1, and Figs. 2, 5 and 6 are respectively block diagrams showing other embodiments according to the invention.

Embodiments of the invention will hereinafter be described in detail with reference to Figs. 1 - 6.

First Embodiment

Fig. 1 shows a circuit configuration of a first embodiment of the present invention. In this figure, reference numeral 21 designates a constant current supplying circuit as a reference current source. The constant current from the constant current supplying circuit 21 is supplied to a current-voltage converting circuit 22 to be converted into a constant voltage which in turn is supplied to a switched capacitor 23. The switched capacitor 23 comprises a capacitor 23a and switches 23b and 23c respectively arranged at both ends of the capacitor 23a. A contact a of the switch 23b is connected to an output side of the current-voltage converter 22 while the other contact b thereof is grounded. Further, a contact a of the switch 23c is connected to an inverting input terminal of an integration circuit 26 comprising a capacitor 24 and a differential amplifier 25 while the other contact b thereof is grounded.

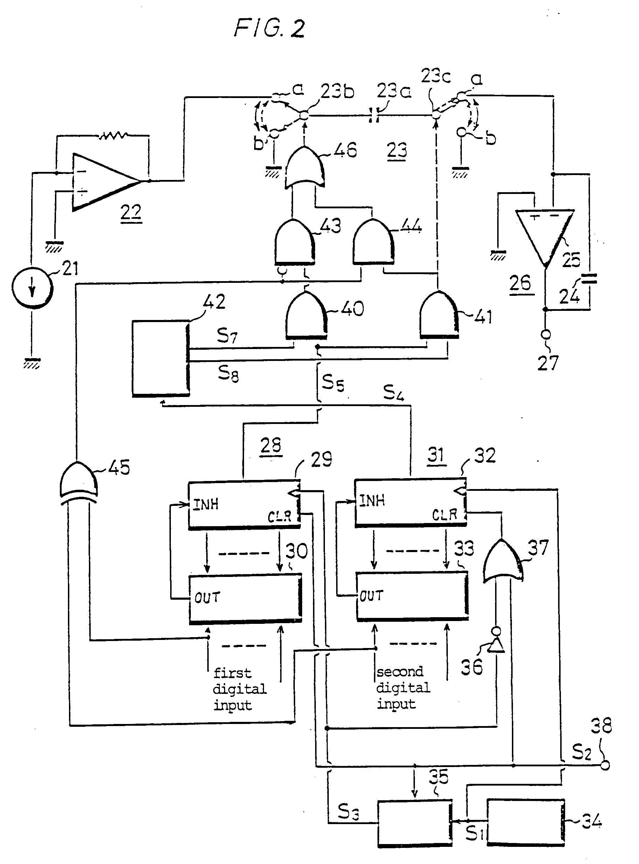

When the switches 23b and 23c are changed over as indicated by solid lines in Fig. 2 by a control signal, hereinafter referred to, the switched capacitor 23 operates as a non inverting circuit. On the other hand, if the switches 23b and 23c are changed over as indicated by broken lines in the same figure, it operates as an inverting circuit. That is, when the switched capacitor 23 operates as a non inverting circuit, if the switch 23b is connected to its contact a, the switch 23c is also connected to its contact a, and if the switch 23b is connected to its contact b, the switch 23c is also connected to its contact b. On the other hand, when the switched capacitor operates as an inverting circuit, if the switch 23b is connected to its contact a, the switch 23c is connected to the contact b, and if the switch 23b is connected to its contact b, the switch 23c to its contact a.

The constant voltage outputted from the current-voltage converter 22 is supplied through thus operating switched capacitor 23 to the integration circuit 26. From the output side of the integration circuit 26 led out is an output terminal 27.

Reference numeral 28 is a first control signal generating circuit formed of a counter 29 and a comparator 30 which generates, under the control of a first digital input signal, a pulse signal having a time width proportional to the value of the first input digital signal as a control signal $S_5$ (Fig. 3E). Assuming that if the first digital input signal has 8-bit length, the time width of the control signal (output pulse) generated from the control signal generator circuit 28 corresponds to the value ranging from the minimum value 0 to the maximum value $2^8 \cdot 1 = 255$. In Fig. 3, hereinafter referred to, the value of the first input digital signal is determined as $01100100_2 = 100_{10}$.

Reference numeral 31 is a second control signal generating circuit formed of a counter 32 and a comparator 33 which generates, under the control of a second digital input signal, a pulse signal having a time width proportional to the value of the second input digital signal as a control signal $S_4$ (Fig. 3D). Assuming that if the second digital input signal has 4-bit length, the time width of the control signal (output pulse) generated from the control signal generating circuit 31 corresponds to the value ranging from the minimum value 1 to the maximum value $2^4 = 16$. In Fig. 1, hereinafter referred to, the value of the second input digital signal is determined as $1101_2 = 13_{10}$.

Reference numeral 34 designates a clock generator. A clock signal $S_1$ (Fig. 3A) from the clock generator 34 is supplied to a 1/16 frequency divider 35 as well as to a clock terminal of the counter 32 of the control signal generating circuit 31. The clock generator 34 should generate, during one sampling dime period, clock pulses whose frequency value is more than or equal to at least a product value (e.g. 16x225 $= 2^4 \times (2^8 \cdot 1)$) obtained by multiplying a pulse number (e.g. 16) corresponding to the time width of the maximum value of the output pulse generated from the control signal generating circuit 31 by a value (e.g. 225) corresponding to the time width of the maximum value of the output pulse generated from the control signal generating circuit 28.

The 1/16 frequency divider 35 is made to include $2^4 = 16$ clock pulses during one cyclic period of the output thereof. An output signal $S_3$ (Fig. 3C) from the 1/16 frequency divider 35 is supplied to a clock terminal of the counter 29 as well as to a clear terminal of the counter 32 through an inverter 36 and an OR circuit 37. The counter 32 is reset at an edge, e.g. at a rising edge of the output signal.

Reference numeral 38 is an input terminal to which is supplied a start signal $S_2$ (Fig. 3B) to turn the whole converter on. The start signal from the input terminal 38 is supplied to the 1/16 frequency divider 35 as a reset signal, a clear terminal of the counter 29, and the clear terminal of the counter 32 through the OR circuit 37.

The control signals $S_5$ and $S_4$ generated from the control signal generating circuits 28 and 31 are both supplied to an AND circuit 39 and an output signal $S_6$ (Fig. 2F) of the AND circuit 39 is supplied to one input terminal of respective AND circuits 40 and 41. Reference numeral 42 designates a clock generator which generates clock signals to change over the switches 23b and 23c of the switched capacitor 23. Generated from the clock generator 42 are two clock signals $S_7$ and $S_8$ having opposite phase to one another as shown in Fig. 4. The signals $S_7$ and $S_8$ are respectively supplied to the other input terminals of the AND circuits 40 and 41. The AND circuits 40 and 41 operate so as to substantially mask the clock signals $S_7$ and $S_8$ from the clock generating circuit 42 by the use of the output signal $S_6$ from the AND circuit 39, whereby the switched capacitor 23 operates only when the control signals $S_5$ and $S_4$ are both outputted simultaneously.

The output signal from the AND circuit 41 is directly used as a control signal for the switch 23c of the switched capacitor 23. The output signals from the AND circuits 40 and 41 are respectively supplied to one input terminal of AND circuits 43 and 44. Further, a bit (MSB) indicative of the polarity of the first digital input signal supplied to the comparator 30 and a bit (MSB) indicative of the polarity of the second digital input signal supplied to the comparator 33 are supplied to an exclusive OR circuit 45, the output signal of which is supplied to the other input terminal of the respective AND circuits 43 and 44.

Incidentally, the output signal of the exclusive OR circuit 45 becomes low level when the first and second digital input signals have the same polarity, and high level when these signals have respectively the different polarities from each other. The AND circuits 43 and 44 substantially determine, by the bits indicative of the polarity of the first and second input digital signals, which of the clock signals $S_7$ and $S_8$

derived from the clock generating circuit 42 is supplied to the switch 23b of the switched capacitor 23, to thereby change over the operation of the switched capacitor 23 from non inverting to inverting. To be specific, when the switch 23c of the switched capacitor 23 is supplied with the clock signal $S_8$ from the clock generator 42 through the AND circuit 41 if the switch 23b is supplied with the clock signal $S_8$ from the clock generator circuit 42 through the AND circuit 44 and the OR circuit 46, the switched capacitor 23 operates as a non-inverting circuit, since there is the in-phase relationship between the signals supplied thereto. On the other hand, if the switch 23b is supplied with the signal $S_7$ from the clock generating circuit 42 through the AND circuit 43 and the OR circuit 46, the switched capacitor 23 operates as an inverting circuit, since there is the anti-phase relationship between the signals supplied thereto.

Next, the operation of the circuit shown in Fig. 2 will be explained with reference to Figs. 3 and 4.

The start signal $S_2$ as shown in Fig. 3B is supplied at a time $t_0$ from the input terminal 33 to the 1/16 frequency divider 35, the clear terminal of the counter 29, and the counter 32 through the OR circuit 37. Then, at a time $t_1$ when the Signal $S_2$ is fallen down, the 1/16 frequency divider 35 and counters 29 and 32 are reset. As a result, at the same time the output signal $S_3$ from the 1/16 frequency divider 35 becomes high level as shown in Fig. 3C, the output signals (control signals) $S_4$ and $S_5$ from the control signal generating circuits 31 and 28 become high level, as shown respectively in Figs. 3D and 3E.

When the output signals $S_4$ and $S_5$ from the control signal generating circuits 31 and 28 become high level, the output signal $S_6$ from the AND circuit 39 also becomes high level, as shown in Fig. 3F. When the signal $S_6$ is supplied to the AND circuits 40 and 41 to open their gates, the clock signals $S_7$ and $S_8$ from the clock generator 42, as shown in Figs. 4A and 4B, pass therethrough. The clock signal $S_8$ through the AND circuit 41 is supplied to the switch 23c of the switched capacitor 23 as a control signal as it is and also to the AND circuit 44. The clock signal $S_7$ through the AND circuit 40 is supplied to the AND circuit 43. It is determined, by the control of the output signal from the exclusive OR circuit 45, which of the clock signal $S_8$ through the AND circuit 44 and the clock signal $S_7$ through the AND circuit 43 is supplied through the OR circuit 46 to the switch 23b of the switched capacitor 23 as a control signal. To be specific, when the output signal from the exclusive OR circuit 46 is at high level, that is, when the first and second digital input signals respectively supplied to the comparators 30 and 33 have the same polarity, the AND circuit 43 closes its gate while the AND circuit 44 opens its gate, and consequently the clock signal $S_8$ through the AND circuit 44 is supplied through the OR circuit 46 to the switch 23b of the switched capacitor 23 as a control signal, whereby at that time the switched capacitor 23 operates as a non inverting circuit. On the other hand, when the output signal from the exclusive OR circuit 46 is at low level, that is, when the first and second digital input signals respectively supplied to the comparators 30 and 33 have different polalities from each other, the AND circuit 44 closes its gate while the AND circuit 43 opens its gate, and consequently the clock signal $S_7$ through the AND circuit 43 is supplied through the OR circuit 46 to the switch 23b of the switched capacitor 23 as a control signal, whereby at that time the switched capacitor 23 operates as an inverting circuit.

When the constant voltage derived from the current-voltage converter 22 is accumulated in the capacitor 23a of the switched capacitor 23 operating as mentioned above, the constant voltage is supplied to the integration circuit 26 to thereby start charging the capacitor 24.

The counters 29 and 31 begin their operation at the time $t_1$, the counter 29 is in a state to count the pulses of the signal $S_3$ supplied thereto from the 1/16 frequency divider 35, while the counter 31 starts sequentially counting the pulses of the clock signal $S_1$, as shown in Fig. 3A, generated from the clock generator 34. Then, at the time $t_2$ the output signal from the 1/16 frequency divider 35 is inverted from high level to low level.

As the value of the second digital input signal supplied to one input side of the comparator 33 is assumed to be $1101_2 = 13_{10}$, as mentioned above, at a time $t_3$, the contents of the counter 31 supplied to the other input side of the comparator 33 become equal to that of the second digital input signal supplied to one input side thereof, so that the comparator 33 generates an output signal which is supplied to an inhibit terminal INH of the counter 32, whereby the contents of the counter 32 is reset to be 0. Consequently, the output signal $S_4$ from the control signal generating circuit 31 also becomes low level as shown in Fig. 3D. During this low level period, the output signal $S_6$ from the AND circuit 39 is also at low level as shown in Fig. 3F, so that the AND gates 40 and 41 do not open their gates. Accordingly, the clock signals $S_7$ and $S_8$ from the clock generator 42 are not supplied to the switched capacitor 23, and therefore the integration circuit 26 is substantially inhibited from being supplied with the constant voltage derived from the constant current supplying circuit 21 through the current-voltage converting circuit 22 and the switched capacitor 23.

At a time $t_4$, the counter 29 starts counting pulses of the signal $S_3$ outputted from the 1/16 frequency divider 35, and the counter 32 is reset by the signal $S_3$ from the 1/16 frequency divier 35 and again starts counting pulses of the clock signal derived from the clock signal generator 34. Also at the time $t_4$, the signal

$S_3$ from the 1/16 frequency divider 35 is inverted from low level to high level.

At a time $t_5$, the signal $S_3$ from the 1/16 frequency divider 35 is again inverted from high level to low level. Next, at a time $t_6$, the same operations as those effected at the time $t_3$ are effected. Then, during a time period between a time $t_7$ and a time $t_{12}$, the above-mentioned operations are repeated.

At a time $t_{13}$, whereat the counted value of pulses of the signal $S_3$ from the 1/16 frequency divider 35 by the counter 29 exceeds the value of the first digital input signal, i.e. $100_{10}$ = $1100100_2$, which is supplied to the one input side of the comparator 30, the comparator 30 outputs to its output terminal a signal which is supplied to an inhibit terminal INH of the counter 29 to thereby reset the content of the counter 29 to zero. Consequently, the output signal $S_5$ from the control signal generating circuit 28 also becomes low level as shown in Fig. 3E, whereby the output signal $S_6$ from the AND circuit 39 also becomes low level, as shown in Fig. 3F, rendering the switched capacitor 23 inoperative, so that the integration circuit 26 is subtantially inhibitted from being supplied with the constant voltage.

At a time $t_{14}$, the start signal $S_2$ is again supplied from the input terminal 38 to the 1/16 frequency divider 35 as a reset signal as well as to the clear terminals of the respective counters 29 and 32. Then, the above-mentioned operations during the time period between the times $t_1$ and $t_3$ are repeated in the same manner. Incidentally, the digital input signals supplied to the comparators 30 and 33 may have values different from those as determined above.

As described above, according to the present embodiment, assuming that on-periods of the switches 23b and 23c are respectively taken as $N_1$ and $N_2$ and an equation $|N| = |N_1 \times N_2|$ is established, an analog output converted from a product of two digital input signal values can be generated by setting $N_1$ and $N_2$ to values corresponding to the two digital input signal values.

Second Embodiment

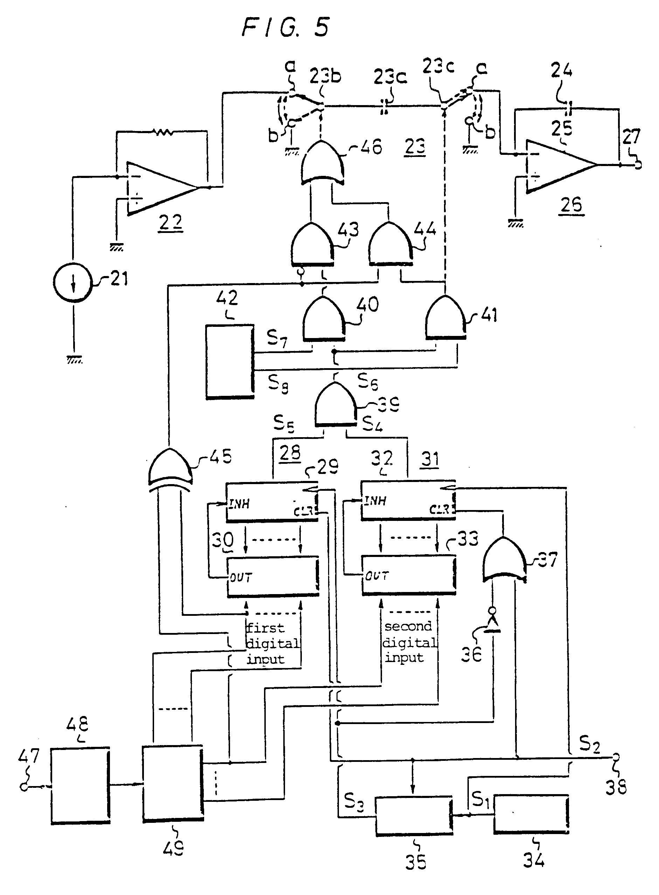

Fig. 5 shows a circuit configuration of a second embodiment of the invention. In the same figure, the same reference numerals designate the same parts in Fig. 2 and the detailled description thereof is omitted.

In the present embodiment, a digital signal supplied to an input terminal 47 is supplied to a difference processing circuit 48 wherein the difference between adjacent sampled values is obtained. Then, the output signal from the difference processing circuit 48 is supplied to a floating-point processing circuit 49 wherein the supplied signal is divided into signals indicative of a mantissa portion and an exponent portion. The mantissa portion is supplied to the comparator 30 as the first digital input signal, and the exponent portion to the comparator 33 as the second input digital signal. The other configuration thereof is the same as that of Fig. 1.

The integration circuit 26 can obtain a desired analog signal at the output terminal 27 by sequentially integrating each sampled value without resetting the same.

The S/N ratio for a medium-low region of the analog signal delivered to the output terminal 27 by this embodiment can be made larger than that of the first digital input signal supplied to the comparator 30.

Third Embodiment

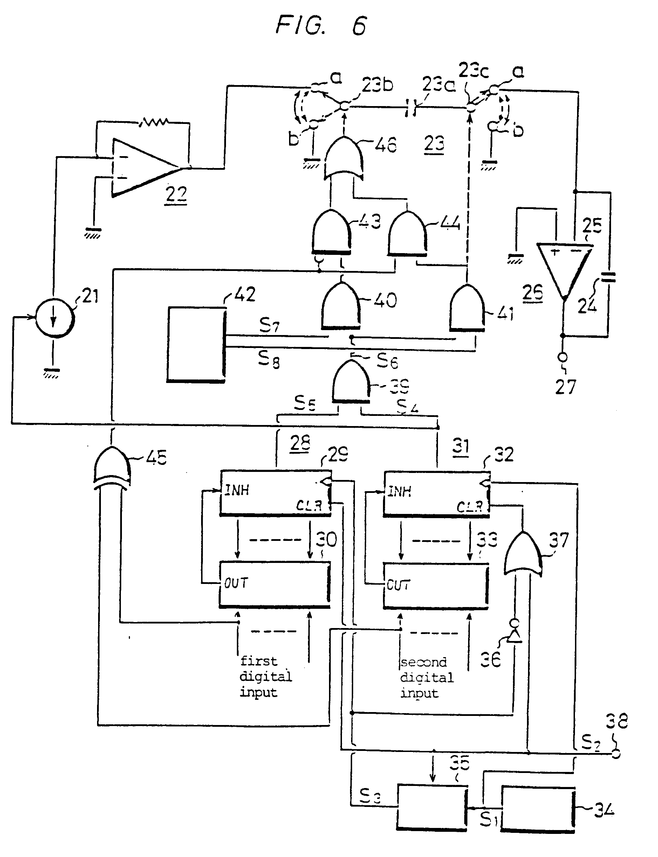

Fig. 6 shows a circuit configuration of a third embodiment of this invention. In this figure, the same reference numerals designate the same parts in Fig. 2 and the detailed description thereof is omitted.

In the present embodiment, the constant current supplying circuit 21 is controlled by the control signal generating circuit 31, and the value of the second input digital signal supplied to the comparator 33 of the control signal generating circuit 31, the pulse width $W_N$ (refer to Fig. 3D) of the control signal $S_4$ derived from the control signal generating circuit 31 and the value of a current I outputted from the constant current supplying circuit 21 have a relationship as shown in the following table:

| Value of Second Input Digital Signal | Pulse Width $W_N$ of Control Signal $S_4$ | Current Value I from Constant Current Circuit 21 |
|---|---|---|
| 1 | 1 | 1 |
| 2 | 2 | 1 |
| 4 | 4 | 1 |
| 8 | 1 | 8 |
| 16 | 2 | 8 |
| 32 | 4 | 8 |

By the above setting, the maximum value of the pulse width $W_N$ of the control signal $S_4$ generated from the control signal generating circuit 31 can be made small and hence, the sampling frequency can be increased, and due to the decrease of an IC clock number the IC production becomes easy.

Fourth Embodiment

Fig. 2 shows a circuit configuration of a fourth embodiment of the invention. In this figure, the same reference numerals designate the same parts in Fig. 2 and the detailed description thereof is omitted.

In the present embodiment, the clock generator 42 generating the clock signals $S_7$ and $S_8$ is controlled by the control signal $S_4$ derived from the control signal generating circuit 31, and the value of the second digital input signal supplied to the comparator 33 is set in correspondence to the frequency of the clock signals $S_7$ and $S_8$ from the clock generator 42, whereby it is possible to generate a number of the pulse signals proportional to the value of the second input digital signal. In this case, the control signal $S_4$ is supplied to the clock generator 42 and the control signal $S_5$ to the AND circuits 40 and 41. Therefore, the AND circuit 39 is not necessary, to thereby simplify the circuit configuration of the present embodiment.

Other Embodiments

In the above explained respective embodiments, the absolute value of at least one of the first and second input digital signals may be determined as $2^n$ (n = 0, 1, 2, ...), which is used for a floating-point calculation.

Further, in each of the above respective embodiments, a plurality of circuit configurations constructed by all the circuit components other than the integration circuit 26 may be connected to the integration circuit 26, wherein if it is assumed that there are N circuits connected to the integration circuit,

$$Vout = \sum_{n-1}^{N} (DI_{1n} \times DI_{2n}) \quad \cdots (1)$$

is obtained. In the above equation (1), Vout is an analog output signal, $DI_{1n}$ represents the first digital input signal supplied to the nth multiplication circuit (corresponding to the circuit constructed by all the circuit components other than the integration circuit 26), and $DI_{2n}$ the second input digital signal supplied to the nth multiplication circuit. By the configuration described above, it is possible to obtain an analog signal representative of added value far larger than the maximum value of each of the input digital signals without occurrence of saturation, which particularly is useful for an output portion of an electronic musical instrument.

In relation to the above-mentioned configuration, a plurality of the control signal generating circuits 28 may be provided. Assuming that there are provided N control signal generating circuits,

$$Vout = \sum_{n-1}^{N} DI_n \quad \cdots (2)$$

is obtained. In the above equation (2), $DI_n$ represents the first digital input signal supplied to the nth control signal generating circuit 28.

Further, it may be possible that each of the aforementioned embodiments may be provided with two constant current supplying circuits of a different value as the constant current circuit 21 to form a continually integrating D/A converter, wherein upper bits of the first digital input signal are converted by the use of the current supplying circuit having a larger current value or both of the current supplying circuits, and lower bits of the first digital input signal is converted by the use of the current supplying circuit having a smaller current value. This embodiment has an advantage of lowering the clock frequency.

As described above, according to the present invention, the switched capacitor arranged between the integration circuit and the constant current supplying circuit is controlled in response to the values of the first and second digital input signals, so that an analog output corresponding to a product of a plurality of input digital signals can be generated by only one D/A converter, whereby the configuration of the circuit is simplified and the producion cost is reduced.

6

EXPLANATION FOR REFERENCE NUMERALS

Reference numeral (21) designates the constant current supplying circuit, (22) the current-voltage converting circuit, (23) the switched capacitor, (26) the integration circuit, (28) the first control signal generating cicuit, (31) the second control signal generating circuit, (34) and (42) the clock generators, (35) the 1/16 frequency divider, (39), (40), (41), (43), and (44) the AND circuits, (45) the exclusive OR circuit, and (46) the OR circuit.

**Claims**

1.  A D/A converter comprising
    - a means (48, 49) for outputting a first digital signal and a second digital signal;
    - a constant voltage generating circuit (21, 22);
    - an integration circuit (26);
    - a switched capacitor circuit (23) arranged between said constant voltage generating circuit and said integration circuit; and
    - a control circuit means (28 - 46) for controlling the operation of said switched capacitor circuit;
    - whereby said integration circuit outputs an analog signal proportional to the product of said first and second digital input signals;

    **characterized in that** said control circuit means comprises:
    - a switching clock generator (42) for outputting switching pulses determining the switching frequency of said switching capacitor circuit;
    - a first control circuit (29, 30, 35) for determining a number of time periods from the value of said first digital signal; and
    - a second control circuit (32, 33, 34) for determining the duration of said time period, during which said switching capacitor means is switched, said duration being dependend from the value of said second digital signal.

2.  A D/A converter according to claim 1, **characterized in that** said means for outputting said first and second digital signals comprises a floating-point processing circuit (49) receiving a digital input signal and outputting the mantissa portion of said input signal as said first digital signal, and the exponent portion of said input signal as said second digital signal.

3.  A D/A converter according to one of the claims 1 or 2,
    **characterized in that**
    - said second control circuit comprises:
      -- a second clock generator (34) for providing second clock pulses (S1) having a frequency corresponding to the highest possible value of said second digital signal;
      -- a second counter (32) for counting said second clock signals; and
      -- a second comparator (33) being set with a value corresponding to the value of said second digital signal;
      -- said second control circuit outputting a signal (S4) of low level as soon as said second comparator indicates that the count number of said second counter agrees with the value of said second digital signal;
    - said first control circuit comprises:
      -- a first clock generator (35) for outputting first clock pulses (S3) having a frequency corresponding to 1/(maximum value of said second signal);
      -- a first counter (30) for counting said first clock signals; and
      -- a first comparator (29) being set with the value corresponding to the value of said first digital signal;
      -- said first control circuit outputting a signal (S5) of low level as soon as said first comparator indicates that the count value of said first counter agrees with the value of said first digital signal; and
    - an AND-gate means (39 - 42; 40 - 42 in Fig. 7) is provided for gating said switching pulses to said switching capacitor circuit (23) only then when the output signal of said first and second control circuits are of high level.

7

**Patentansprüche**

1. D/A-Wandler mit:
   - einer Einrichtung (48, 49) zum Ausgeben eines ersten digitalen Signals und eines zweiten digitalen Signals;
   - einer Konstantspannungserzeugungsschaltung (21, 22);
   - einer Integrierschaltung (26);
   - einer Schaltkondensatorstufe (23), die zwischen die Konstantspannungserzeugungsschaltung und die Integrierschaltung geschaltet ist; und
   - einer Steuerschaltungseinrichtung (28 - 46) zum Steuern des Betriebs der Schaltkondensatorstufe,
   - wobei die Integrierschaltung ein analoges Signal ausgibt, das proportional zum Produkt des ersten und des zweiten digitalen Eingangssignals ist;
   **dadurch gekennzeichnet**, daß
   die Steuerschaltungseinrichtung folgendes aufweist:
   - einen Schalttaktgenerator (42) zum Ausgeben von Schaltpulsen, die die Schaltfrequenz der Schaltkondensatorstufe bestimmen;
   - eine erste Steuerschaltung (29, 30, 35) zum Bestimmen einer Anzahl von Zeitspannen aus dem Wert des ersten digitalen Signals; und
   - eine zweite Steuerschaltung (32, 33, 34) zum Bestimmen der Dauer der Zeitspanne, während der der Schaltkondensator geschaltet ist, welche Dauer vom Wert des zweiten digitalen Signals abhängt.

2. D/A-Wandler nach Anspruch 1, **dadurch gekennzeichnet**, daß die Einrichtung zum Ausgeben des ersten und des zweiten digitalen Signals eine Fließpunktverarbeitungsschaltung (49) aufweist, die das digitale Eingangssignal empfängt und den Mantissenteil des Eingangssignals als erstes digitales Signal und den Exponententeil des Eingangssignals als zweites digitales Signal ausgibt.

3. D/A-Wandler nach einem der Ansprüche 1 oder 2, **dadurch gekennzeichnet**, daß
   - die zweite Steuerschaltung folgendes aufweist:
     -- einen zweiten Taktgenerator (34) zum Erzeugen zweiter Taktpulse (S1) mit einer Frequenz, die dem großtmöglichen Wert des zweiten digitalen Signals entspricht;
     -- einen zweiten Zähler (32) zum Zählen der zweiten Taktsignale; und
     -- einen zweiten Komparator (33), der mit einem Wert eingestellt wird, der dem Wert des zweiten digitalen Signals entspricht;
     -- wobei die zweite Steuerschaltung ein Signal (S4) niedrigen Pegels ausgibt, sobald der zweite Komparator anzeigt, daß der Zählwert des zweiten Zählers mit dem Wert des zweiten digitalen Signals übereinstimmt;
   - die erste Steuerschaltung folgendes aufweist:
     -- einen ersten Taktgenerator (35) zum Ausgeben erster Taktpulse (S3) mit einer Frequenz, die 1/(Maximalwert des zweiten Signals) entspricht;
     -- einen ersten Zähler (30) zum Zählen der ersten Taktsignale; und
     -- einen ersten Komparator (39), der mit einem Wert gesetzt wird, der dem Wert des ersten digitalen Signals entspricht;
     -- wobei die erste Steuerschaltung ein Signal (S5) niedrigen Pegels ausgibt, sobald der erste Komparator anzeigt, daß der Zählwert des ersten Zählers mit dem Wert des ersten digitalen Signals übereinstimmt; und
   - eine UND-Gatter-Einrichtung (39 - 42; 40 - 42 in Fig. 7) ist vorhanden, um die Schaltpulse an die Schaltkondensatorstufe (23) nur dann durchzulassen, wenn die Ausgangssignale der ersten und der zweiten Steuerschaltung auf hohem Pegel sind.

**Revendications**

1. Convertisseur numérique/analogique (N/A) comprenant :
   un moyen (48, 49) pour émettre en sortie un premier signal numérique et un second signal numérique ;
   un circuit de génération de tension constante (21, 22) ;
   un circuit d'intégration (26);

un circuit à capacités commutées (23) agencé entre ledit circuit de génération de tension constante et ledit circuit d'intégration ; et

un moyen de circuit de commande (28 - 46) pour commander le fonctionnement dudit circuit à capacités commutées ;

d'où il résulte que ledit circuit d'intégration émet en sortie un signal analogique proportionnel au produit desdits premier et second signaux d'entrée;

caractérisé en ce que ledit moyen de circuit de commande comprend :

un générateur d'horloge de commutation (42) pour émettre en sortie des impulsions de commutation qui déterminent la fréquence de commutation dudit circuit à capacités commutées:

un premier circuit de commande (29, 30, 35) pour déterminer un certain nombre de périodes temporelles à partir de la valeur dudit premier signal numérique ; et

un second circuit de commande (32, 33, 34) pour déterminer la durée de ladite période temporelle, durée pendant laquelle ledit moyen à capacités commutées est commuté, ladite durée dépendant de la valeur dudit second signal numérique.

2.  Convertisseur N/A selon la revendication 1, caractérisé en ce que ledit moyen pour émettre en sortie lesdits premier et second signaux numériques comprend un circuit de traitement en virgule flottante (49) qui reçoit un signal d'entrée numérique et qui émet en sortie la partie de mantisse dudit signal d'entrée en tant que dit premier signal numérique et la partie d'exponentielle dudit signal d'entrée en tant que dit second signal numérique.

3.  Convertisseur N/A selon la revendication 1 ou 2, caractérisé en ce que :

ledit second circuit de commande comprend :

un second générateur d'horloge (34) pour produire des secondes impulsions d'horloge (S1) présentant une fréquence correspondant à la valeur la plus élevée possible dudit second signal numérique ;

un second compteur (32) pour compter lesdits seconds signaux d'horloge ; et

un second comparateur (33) qui est établi avec une valeur correspondant à la valeur dudit second signal numérique ;

ledit second circuit de commande émettant en sortie un signal (S4) de niveau bas aussitôt que ledit second comparateur indique que la valeur de comptage dudit second compteur correspond à la valeur dudit second signal numérique ;

ledit premier circuit de commande comprend :

un premier générateur d'horloge (35) pour émettre en sortie des premières impulsions d'horloge (S3) présentant une fréquence correspondant à 1/(valeur maximale dudit second signal) ;

un premier compteur (30) pour compter lesdits premiers signaux d'horloge ; et

un premier comparateur (29) qui est établi avec la valeur correspondant à la valeur dudit premier signal numérique ;

ledit premier circuit de commande émettant en sortie un signal (S5) de niveau bas aussitôt que ledit premier comparateur indique que la valeur de comptage dudit premier compteur correspond à la valeur dudit premier signal numérique ; et

un moyen de porte ET (39 - 42 ; 40 - 42 sur la figure 7) est prévu pour soumettre à une logique de porte lesdites impulsions de commutation et les appliquer audit circuit à capacités commutées (23) seulement lorsque le signal de sortie desdits premier et second circuits de commande est à un niveau haut.

FIG. 1

FIG. 2

FIG. 3A S₁

FIG. 3B S₂

FIG. 3C S₃

FIG. 3D S₄

FIG. 3E S₅

FIG. 3F S₆

FIG. 4A (S₇)

FIG. 4B (S₈)

1 cyclic period

EP 0 222 021 B1

F I G. 5

## FIG. 6